(19) Europäisches Patentamt
European Patent Office
Office européen des brevets

(11) **EP 0 996 169 A2**

(12) **EUROPEAN PATENT APPLICATION**

(43) Date of publication:
26.04.2000 Bulletin 2000/17

(51) Int. Cl.⁷: **H01L 31/0352**

(21) Application number: **99120752.3**

(22) Date of filing: **20.10.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **21.10.1998 JP 29950798**

(71) Applicant:
**Canare Electric Co., Ltd.
Aichi-gun, Aichi-ken 480-1101 (JP)**

(72) Inventor: **Kano, Hiroyuki
Nishikamo-gun, Aichi-ken 470-0201 (JP)**

(74) Representative:
**Pellmann, Hans-Bernd, Dipl.-Ing. et al
Patentanwaltsbüro
Tiedtke-Bühling-Kinne & Partner
Bavariaring 4
80336 München (DE)**

(54) **Semiconductor device with a carrier confinement layer**

(57)     Plurality of multi-period layer units with a plural-layer structure, having plural periods of a pair of a first layer W and a second layer B are formed in a semiconductor device. The second layer B has wider band gap than the first layer W. A carrier confinement layer having a wider band width than the first layer W is formed at each interface of the multi-period layer units, and plurality of multi-period layer units are connected in series. Accordingly, a semiconductor device with a first structure is formed. Plurality of multi-period layer units with a plural-layer structure, having plural periods of a pair of a first layer W and a second layer B are formed in a semiconductor device. The second layer B has wider band gap than the first layer W. A carrier confinement layer having a narrower band width than the second layer B is formed at each interface of the multi-period layer units, and plurality of multi-period layer units are connected in series. Accordingly, a semiconductor device with a second structure is formed. The semiconductor device having the first structure can be effectively applied to a pin-type photodiode and a voltage-variable capacity, and the semiconductor device having the second structure can be effectively applied to a light-receiving device.

F I G. 7

EP 0 996 169 A2

**Description**

BACKGROUND OF THE INVENTION

Field of the invention

The present invention relates to a semiconductor device having a new structure. The new structure of the present invention is effective to an opto-electric conversion device, or a light-receiving device, or other pin diode, a variable capacity device having an nin, pip, pn⁻n, pp⁻n or pin junction structure.

Description of the Related Art

Pin diodes having the same characteristic of rectification as that of pn diodes are known. Also known are avalanche diodes, and Impact Avalanche Transit Time (IMPATT) diodes used by applying a backward voltage.

Also, a light-receiving device has been known to have a pin junction structure. A backward voltage is applied to the pin layers of the device, and electron-hole pairs are generated by that light incided from the side of a p-layer is absorbed in an i-layer. the electron-hole pairs excited in the i-layer are accelerated by a backward voltage in the i-layer, and electrons and holes are flowing into an n-layer and a p-layer, respectively. Thus a photocurrent whose intensity varies according to an intensity of the incident light is outputted.

And a voltage-variable capacity device has been known to have a pn junction structure, whose p-layer having a high impurity concentration and n-layer having a low impurity concentration are jointed and form a depletion layer at a boundary region between the p-layer and the n-layer as a capacity device. When a reverse bias voltage is applied to the pn junction of the variable capacity device, a width of the depletion layer is extended and a capacity of the variable capacity device is reduced. Thus the capacity of the device varies according to a value of applied reverse bias voltage.

However, a problem persists in the above semiconductor devices.

The I-V characteristics of these diodes have a problem in that they are difficult to change because they are determined by the semiconductor materials constituting the diodes. Therefore, further improvement is required.

To improve an opto-electric conversion effectivity, the i-layer which absorbs light is formed to have a comparatively larger thickness. But when the thickness of the i-layer becomes thicker, more times are needed to draw carriers to the n-layer and the p-layer. As a result, the response velocity of the opto-electric conversion is lowered. To improve the velocity, an electric field in the i-layer is increased by increasing a backward voltage. But when the backward voltage is enlarged, an element separation become difficult and a leakage current is occurred. As a result, an photocurrent which flows when the device is not incided by light, or a dark current, is increased.

Thus conventional light-receiving devices had an interrelation among a light-receiving sensitivity, a detecting velocity, and a noise current, which restricts their performances.

With respect to the voltage-variable capacity device, it is required to enlarge a variation rate of a capacity value toward an applied voltage. To enlarge the variation rate, forming space distribution in an impurity concentration has been suggested. And to enlarge the voltage variation rate, i.e., voltage-sensitivity, the impurity concentration is required to have a non-linear distribution with respect to a depth.

To obtain the non-linear distribution of the impurity concentration, injecting ions whose acceleration voltage is varied, or a modulation doping in the process of a crystal growth is suggested. But because of a thermal diffusion of impurities, it is difficult to obtain the non-linear distribution as accurate as designed. Thus improvement of the voltage-variation rate of capacity is limited.

SUMMARY OF THE INVENTION

It is, therefore, an object of the present invention to provide a semiconductor device having a new structure.

An object of the present invention is to change the I-V characteristics when the backward voltage is applied to the pin diode.

Another object of the present invention is to improve the light-receiving sensitivity and the response velocity of the opto-electric conversion by providing a light-receiving device having a pin junction of a completely new structure.

With respect to a voltage-variation rate of a depletion layer in the present invention, it is realized not to a variation rate of a distribution of impurity, but to a totally new structure. It is, therefore, an object of the present invention to provide a voltage-variable capacity device with high voltage-variation rate, i.e., high voltage sensitivity. Another object of the present invention is to improve a precision of a capacity controlled by an external voltage. The other object of the present invention is to expand a dynamic range of an applied voltage.

In light of these objects a first aspect of the present invention is a semiconductor device constituted by a multi-period layer units and a carrier confinement layer therebetween. The multi-period layer unit has plural periods of a pair of a first layer and a second layer as a unit. The second layer has a wider band gap than the first layer. A carrier confinement layer is formed between the adjacent two of the multi-period layer units. A band gap of the carrier confinement layer is wider than that of the first layer.

The second aspect of the present invention is to make the semiconductor device of the first aspect to be a pin-type diode, having a carrier confinement layer and a multi-period layer unit in an i-layer.

The third aspect of the present invention is to form a light-receiving part in a p-layer or an n-layer of the pin diode of the second aspect. The light-receiving part generates carriers which is injected to the i-layer.

The fourth aspect of the present invention is a semiconductor device constituted by a multi-period layer unit having plural periods of a pair of a first layer and a second layer as a unit. The second layer has a wider band gap than the first layer. A carrier confinement layer is formed between the adjacent two multi-period layer units. A band gap of the carrier confinement layer is narrower than that of the second layer.

The fifth aspect of the present invention is to make the semiconductor device of the fourth aspect to be a light-receiving device having a pin junction structure. And a carrier confinement layer and a multi-period layer unit are formed in an i-layer.

The sixth aspect of the present invention is to make the semiconductor device of the fourth aspect to be a light-receiving device having a carrier confinement layer and a multi-period layer unit that are formed in an n-layer or a p-layer.

The seventh aspect of the present invention is to make a semiconductor device of the sixth aspect to be a device having a pn junction structure.

The eighth aspect of the present invention is to form a carrier confinement layer, having the same band width as that of the first layer, in the semiconductor device of one of the first, fourth and sixth aspect of the present invention.

The ninth aspect of the present invention is to make the semiconductor device of the first aspect to be a variable capacity device having an nin or pip junction structure. A carrier confinement layer and a multi-period layer unit are formed in an i-layer of the variable capacity device.

The tenth aspect of the present invention is to make the semiconductor device of the first aspect to be a variable capacity device having a pn⁻n, pp⁻n or pin junction structure. A carrier confinement layer and a multi-period layer unit are formed in an n⁻-layer, p⁻-layer or an i-layer.

The eleventh aspect of the present invention is to form a carrier confinement layer, having the same band width as that of the second layer, in the semiconductor device of the first or the third aspect, and the ninth or the tenth aspects of the present invention.

(first, second, and third aspects of the present invention)

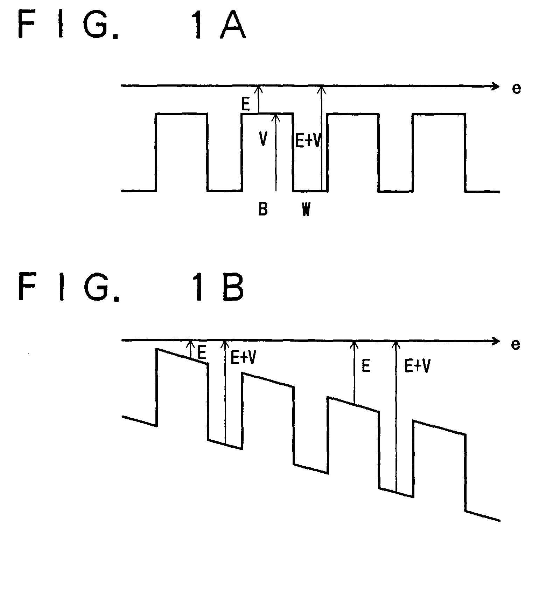

The principle of the multi-period layer of the present invention is explained hereinafter. FIG. 1A shows a conduction band of a multi-period layer formed in an i-layer. Electrons, or minority carriers, are injected into the i-layer, or conduct from left to right as shown by an arrow in FIGS. 1A and 1B. Among the electrons, those that exist near the bottom of the conduction band of the second layer B are likely to contribute to conduction. The electrons near the bottom of the conduction band of the second layer B have a kinetic energy E. Accordingly, the electrons in the first layer W have a kinetic energy E+V and are thus accelerated by the potential energy V due to the band gap difference between the first layer W and the second layer B. In other words, electrons that move from the first layer W to the second layer B are decelerated by the potential energy V and return to their original kinetic energy E in the second layer B. As explained above, the kinetic energy of electrons in the conduction band is modulated by the potential energy due to the multi-layer structure.

When thicknesses of the first layer W and the second layer B are equal to order of quantum-wave wavelength, electrons tend to have characteristics of a wave. Then an interference effect of quantum-wave of electrons can be expected. Because electrons tend to have characteristics of a wave, Takagi et al. (Japanese Journal of Applied Physics. Vol.29, No.11, November 1990, pp.L1977-L1980) discloses that a multi-period layer, in which a first layer W and a second layer B are laminated under the conditions represented by the following Eqs. 1 and 2, functions as an electron reflecting layer.

$$2L_1(2m_1{}^*E_1)^{1/2}2\pi/h = (2m-1)\pi \qquad (1)$$

$$2L_2(2m_2{}^*E_2)^{1/2}2\pi/h = (2n-1)\pi \qquad (2)$$

In Eqs. 1 and 2, $L_1$ and $L_2$; $m_1{}^*$ and $m_2{}^*$; and $E_1$ and $E_2$ represents thicknesses of the first layer W and the second layer B; effective mass of electrons; and an energy of electrons, respectively. h, and m and n represents Plank's constant, and odd numbers, respectively.

Thus the conventional invention shows that with respect to a quantum-wave of conduction electrons in a certain condition, each thickness of the first and the second layers is determined by multiplying by odd number one fourth of quantum-wave wavelength in each of the first and the second layers. While Takagi shows multi-quantum barriers each having a band gap energy represented by $E_1$ and $E_2$ equal to 2V, respectively, the inventor of the present invention suggests a multi-period layer which functions as a reflecting layer with much smaller energy than V. In short, $E_1$ and $E_2$ in Eqs. 1 and 2 is prefer to be defined as the kinetic energy of the electrons at the level near the lowest energy level of the conduction band of the second layer B. Beside, if only a multi-period layer functions as an electron reflecting layer, the present invention is not necessary to be limited to the multi-period layer satisfied with the disclosed condition above.

When the backward voltage is applied to a diode having a multi-period layer in the i-layer, which is formed by laminating the first layer W and the second layer B and functions as an electron reflecting layer, the energy level of the multi-period layer band inclines by the external voltage as shown in FIG. 1B. Then E+V and E, or kinetic energy of the electrons in the first layer W and the second layer B respectively, increase according to a propagating of quantum-wave. Accordingly, the thicknesses of the first layer W and the second layer B no longer improve the quantum-wave reflectivity of the electrons injected into the i-layer. Consequently, in the range of applied voltage for which the energy of electrons does not exceed the energy level used to design the thickness of the multi-period layer, the electrons are reflected and do not cause electric current. But when the applied voltage increases to the degree that the kinetic energy of the electrons injected into the i-layer exceeds the energy level used to design the thickness of the multi-period layer, reflected electrons begin to flow rapidly. Consequently, I-V characteristic of the diode varies rapidly. In short, the dynamic resistance of the diode drops.

The thicknesses of the first layer W and the second layer B are determined for selectively reflecting either the holes or the electrons, because of the difference in potential energy between the valence and the conduction bands, and the difference in effective mass of holes and electrons in the first layer W and the second layer B. In other words, the optimum thickness for reflecting electrons is not the optimum thickness reflecting holes. The thickness for selectively reflecting electrons is designed based on the difference in the potential energy of the conduction band and on the effective mass of electrons.

Further, the thickness for selectively reflecting holes is designed based on the difference in the potential energy of the valence band and on the effective mass of holes, forming another type of multi-period layer in an n-layer for reflecting only holes and allowing electrons to pass through.

Forming the multi-period layers of electrons in a p-layer as described above enable I-V characteristic of the diode to vary rapidly and the dynamic resistance of the diode to be lowered sharply.

Multi-period layer units having a plurality of multi-layer structures are connected in series and at certain intervals, and a carrier confinement layer, which has a wider band gap than the first layer W, is formed between the respective multi-period layer units. Then I-V characteristic of each multi-period layer units varies in accordance with the quantity of carriers accumulated in the carrier confinement layer. That is, the diode of the present invention can be used as a semiconductor diode, i.e., a photodiode, which detects a generation of carriers by an external factor.

By forming the carrier confinement layers and the multi-period layer units described above in an i-layer, I-V characteristic of the diode can be varied in a step at various points.

And by forming a light-receiving part in a p-layer or an n-layer which generates carriers to inject into the i-layer, the diode of the present invention can be used as a photodiode such as a light detector.

(fourth to seventh aspects of the present invention)

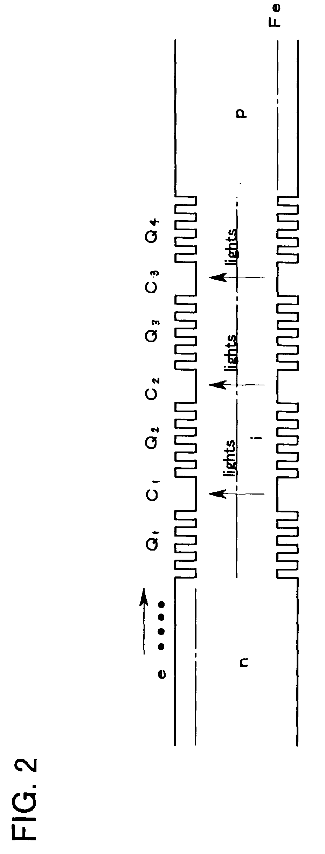

The principle of the light-receiving device of the present invention is explained hereinafter. FIG. 2 shows an energy diagram of a conduction band and a valence band when an external voltage is applied to the interval between the p-layer and the n-layer in a forward direction. As shown in FIG. 2, the conduction band of the i-layer becomes plane by applying the external voltage. Four multi-period layer units $Q_1$ to $Q_4$ are formed in the i-layer, and carrier confinement layers $C_1$ to $C_3$, having a narrower band gap than the second layer, are formed at each intervals of the multi-period layer units. A conduction band of a multi-period layer unit $Q_1$ is as shown in FIG. 1A.

As explained in the first to third aspects of the present invention, kinetic energy of electrons in the conduction band is modulated by potential energy due to the multi-layer structure.

When thicknesses of the first layer W and the second layer B are equal to order of quantum-wave wavelength, electrons tend to have characteristics of a wave. When the multi-period layer is formed by the first layer W and the second layer B, whose thicknesses are determined so as to satisfy equations 1 and 2, the multi-period layer functions as an electron reflecting layer.

When light is incided to the i-layer, electrons excited in conduction bands of the carrier confinement layer $C_1$, $C_2$ and $C_3$ having narrower band gaps are confined therein. The excited electrons tend to flow to the p-layer by applying the forward voltage, but the electrons do not flow because a reflection condition is satisfied for electrons in the multi-period layer unit which exists at the side toward the p-layer.

But when the electrons existing in the carrier confinement layers $C_1$, $C_2$ and $C_3$ are increased, electrons tend to exist in higher level. Then a kinetic energy of the electrons existing in higher level increases, and the electrons are not reflected by the multi-period layer units because of unsatisfaction of the reflection condition. As a result, the electrons passes the multi-period layer units $Q_2$, $Q_3$, and $Q_4$ and flow toward the p-layer, which occurs a photocurrent.

Because a forward voltage is applied to the light-receiving device, driving at a low voltage becomes possible and an element isolating separation become easier. When light is not incided, electrons are reflected in the multi-period layer units effectively. As a result, an electric current does not occur and a dark current can be substantially lowered. The present inventor thinks that electrons is conducted in the multi-period layer units as a wave. Accordingly, a response velocity is considered to become larger.

The holes existing in the valence band of the multi-period layer unit behave as explained in the first to third aspects of the present invention. Consequently, the multi-period layer having the structure described above can reflect only electrons and allowing holes to pass through. Further, thicknesses of the first layer W and the second layer B are designed based on the difference in the potential energy of the valence band and on the effective mass of holes, forming another type of multi-period layer in an n-layer for reflecting only holes and allowing electrons to pass through. Accordingly, the multi-period layer unit which reflects holes and functions as a hole reflecting layer can be formed to connect in series to each of the multi-period layer units described above, which reflects only holes.

The light-receiving device described above having a multi-period layer unit can have a state not to occur electric current by reflecting carriers selectively in a range of 0 V to a certain value of a bias voltage. Accordingly, the light-receiving device can be formed by only one of the n-layer and the p-layer in which the multi-period layer units and the carrier confinement layer are formed. Alternatively, the light-receiving device can be formed by a pn junction structure with a p-layer and an n-layer, in at least one of which the multi-period layer units and the carrier confinement layer are formed.

(eighth aspect of the present invention)

The eighth aspect of the present invention is to form the band width of the carrier confinement layer to have the same band width as that of the first layer W. Each pairs of electron and hole generated by irradiating light are easily accumulated in a conduction band and a valence band of the carrier confinement layer. Because the carrier confinement layer has the same band width as that of the first layer W, carriers existing in the carrier confinement layer behave as those existing in the multi-period layer unit. Consequently, an ability of the light-receiving device is improved.

(ninth aspect of the present invention)

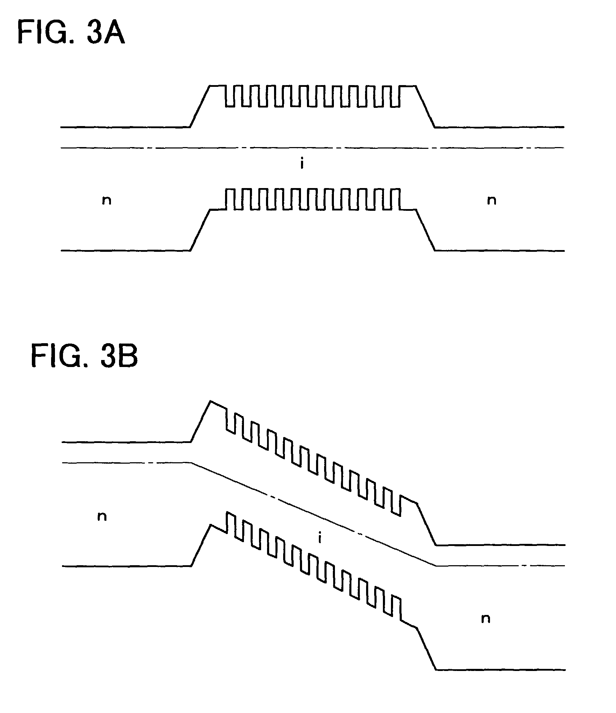

The principle of a carrier confinement layer or a multi-period layer of the present invention is explained hereinafter, referring to an nin structure shown in FIGS. 3A and 3B as an example. As explained in the first to third aspects of the present invention, kinetic energy of electrons in the conduction band is modulated by potential energy due to the multi-layer structure. When thicknesses of the first layer W and the second layer B are equal to order of quantum-wave wavelength, electrons tend to have characteristics of a wave. When the multi-period layer is formed by the first layer W and the second layer B, whose thicknesses are determined so as to satisfy equations 1 and 2, the multi-period layer functions as an electron reflecting layer.

When a voltage applied to the i-layer is enlarged, an effective thickness of the i-layer, or a thickness of a depletion layer, becomes smaller and a capacity of that becomes bigger because of electrons existing in the i-layer, while a reflection of the multi-period layer is effective and carriers do not pass through the i-layer. FIGS. 1B and 3B show an energy level gradient occurring in the multi-period layer on the condition that the external voltage is applied to the i-layer. Then E+V and E, kinetic energies of the first layer W and the second layer B, respectively, are enlarged according to propagation of the quantum-wave, and each thickness of the first layer W and the second layer B become apart from the most suitable condition to have an effective reflectivity. As a result, when an applied voltage is in a range where a kinetic energy of electrons is not larger than that used to design a thickness of the first layer and the second layer in the multi-period layer, electrons are reflected and they do not occur electric current. But when an applied voltage is in a range where a kinetic energy of electrons existing in the i-layer is larger than a predetermined value, the electrons in the i-layer are accelerated and moved by an electric field. Then an electric concentration of the i-layer is decreased, an effective thickness of the i-layer, or a thickness of the depletion layer is effectively enlarged, and a capacity of the i-layer becomes smaller.

The thickness of the first layer W and the second layer B are determined for selectively reflecting the holes or the electrons, because of the difference in potential energy between the valence and the conduction bands, and the difference in effective mass of holes and electrons in the first layer W and the second layer B. In other words, the optimum thickness for reflecting electrons is not the optimum thickness for reflecting holes. Accordingly, holes do not exist in the i-layer when the applied voltage is small, and the i-layer is completely depleted with respect to holes.

Plurality of multi-period layer units and a carrier confinement layer formed between each of the multi-period layer units, are cascaded, i.e., connected in series, and a capacity of the device is enlarged.

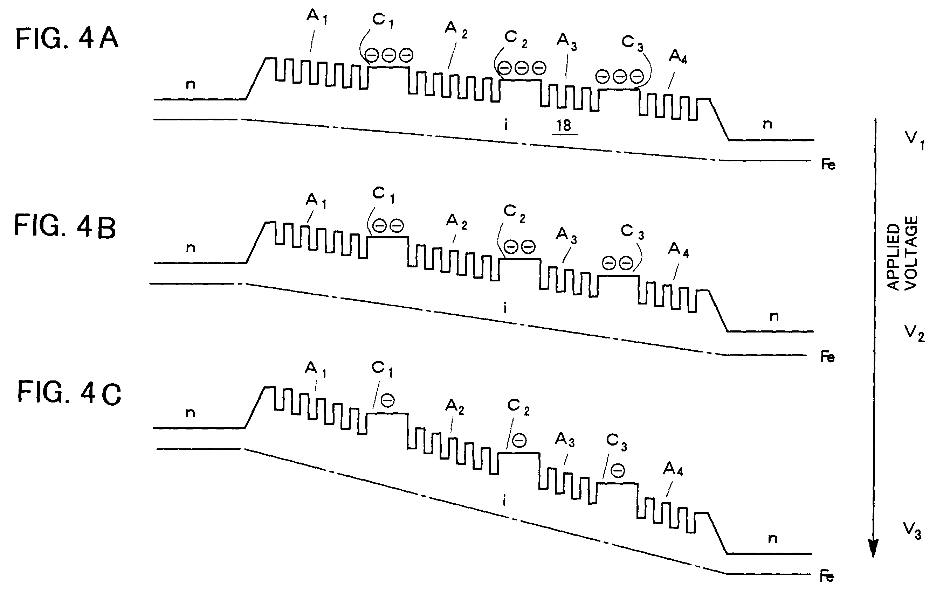

FIGS. 4A to 4C show the structure of the multi-period layer. Each multi-period layer units $A_1$ to $A_4$ are formed at certain intervals, and each carrier confinement layers $C_1$ to $C_3$ are formed at the interval of each multi-period layer units $A_1$ to $A_4$. Electrons existing in the i-layer are confined effectively by the carrier confinement layers $C_1$ to $C_3$, and a capacity of the device is enlarged. When an applied voltage is increased, a quantum-wave wavelength of electrons existing in each multi-period layer units $A_1$ to $A_4$ do not satisfy a condition to reflect electrons, which are accelerated to flow by an electric field of the i-layer. Accordingly, an electron concentration of each carrier confinement layers $C_1$ to $C_3$ is decreased, and the capacity of the i-layer becomes smaller. Thus controlling the capacity is possible by applying an external voltage.

Alternatively, the nin-type can be an pip-type and carriers can be holes alternative to electrons.

(eleventh aspect of the present invention)

The eleventh aspect of the present invention is to form the band width of the carrier confinement layer to have the same band width as that of the second layer B. Because of that, carriers existing in the carrier confinement layer behave as those existing in the multi-period layer unit. Consequently, an ability of the variable capacity device is improved.

(tenth aspect of the present invention)

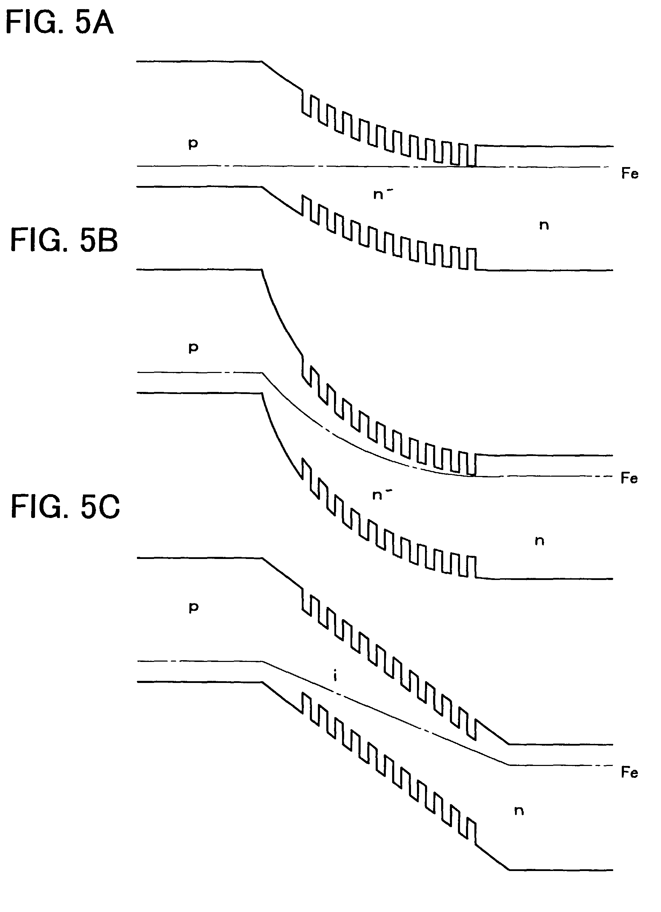

The principle of the carrier confinement layer and the multi-period layer of the present invention is explained hereinafter, referring to an nn⁻p structure shown in FIGS. 5A to 5C as an example. FIG. 1A shows a conduction band of a multi-period layer having a multi-layer structure with plural periods of a first layer W and a second layer B as a unit formed in an n⁻-layer. As explained in the ninth aspect of the present invention, when the multi-period layer is formed by the first layer W and the second layer B, whose thicknesses are determined so as to satisfy equations 1 and 2, the multi-period layer functions as an electron reflecting layer.

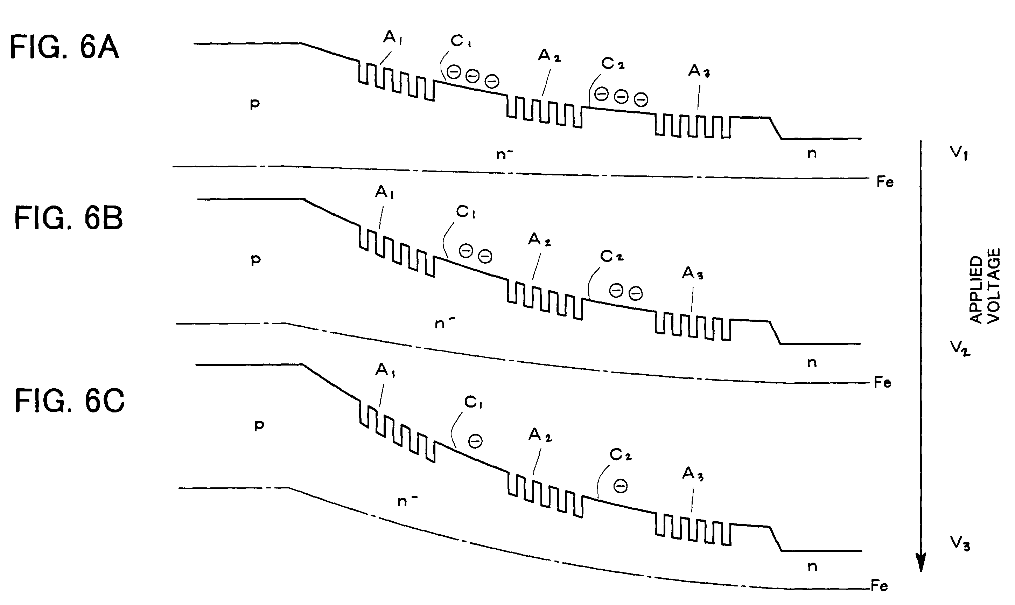

As shown in FIGS. 6A to 6C, when a voltage applied to the n⁻-layer is enlarged, electrons existing in the n⁻-layer behave completely the same as those existing in the i-layer of an nin-type variable capacity device shown in FIGS. 4A to 4C. Then an electric concentration of the n⁻-layer is decreased, an effective thickness of the n⁻-layer, or a thickness of the depletion layer is enlarged, and a capacity of the n⁻-layer becomes smaller.

The holes existing in the valence band of the multi-period layer unit behave completely the same as those in the i-layer of the nin-type variable capacity device. Accordingly, holes do not exist in the n⁻-layer when the applied voltage is small, and the n⁻-layer is completely depleted with respect to holes.

A plurality of multi-period layer units and a carrier confinement layer formed between each of the multi-period layer units, are cascaded, i.e., connected in series, and a capacity of the device is enlarged.

Alternatively, the pn⁻n structure can be a pp⁻n or pin structure.

BRIEF DESCRIPTION OF THE DRAWINGS

Other objects, features, and characteristics of the present invention will become apparent upon consideration of the following description and the appended claims with reference to the accompanying drawings, all of which form a part of the specification, and wherein reference numerals designate corresponding parts in the various figures, wherein:

FIGS. 1A and 1B are explanatory views of a conduction band of a multi-layer structure according to the first to third aspects of the present invention;
FIG. 2 is a view showing the energy diagram of a multi-period layer according to the fourth to seventh aspects of the present invention (Example 2);
FIGS. 3A and 3B are views showing the energy diagram of a multi-period layer according to the ninth aspect of the present invention;
FIGS. 4A-4C are explanatory views showing the energy diagrams of the i-layer of the diode according to the ninth and eleventh aspects of the present invention (Example 3);
FIGS. 5A-5C are views showing the energy diagram of a multi-period layer according to the tenth aspect of the present invention;
FIGS. 6A-6C are explanatory views showing the energy diagrams of the i-layer of the diode according to the tenth aspect of the present invention (Example 4);
FIG. 7 is a sectional view showing the first exemplary structure of a pin diode 100 in Example 1;
FIGS. 8A-8C are explanatory views of δ layers according to the present invention;
FIGS. 9A-9C are views showing the energy diagrams of the i-layer of the pin diode when the external backward voltage is applied thereto (Example 1);
FIG. 10 is a graph showing I-V characteristic of the pin diode when the backward voltage is applied thereto (Example 1);
FIG. 11 is a graph showing I-V characteristic of the pin diode when irradiated by light and when the inverse voltage is applied thereto (Example 1);
FIG. 12 is a sectional view of a light-receiving device 200 in Example 2;
FIG. 13 is a graph showing I-V characteristic of the light-receiving device 200 when incided or not incided by light;
FIG. 14 is an explanatory view showing a structure of a light-receiving device 300;
FIG. 15 is a graph showing I-V characteristic of the light-receiving device 300 when incided or not incided by light;
FIG. 16 is an explanatory view showing a structure of a light-receiving device 400;
FIG. 17 is a graph showing I-V characteristic of he light-receiving device 400 when incided or not incided by light;
FIG. 18 is a sectional view showing a first exemplary structure of a nin variable capacity device 500 in Example 3;
FIG. 19 is a graph showing a voltage characteristic of an alternating current capacity of the variable capacity device in Example 3;
FIG. 20 is a sectional view showing a first exemplary structure of a pn⁻n variable capacity device 600 in Example 4 an 5;

FIG. 21 is a graph showing a voltage characteristic of an alternating current capacity of the variable capacity device in Example 5;

FIG. 22 is a graph showing a voltage characteristic of an alternating current capacity of the variable capacity device in Example 5; and

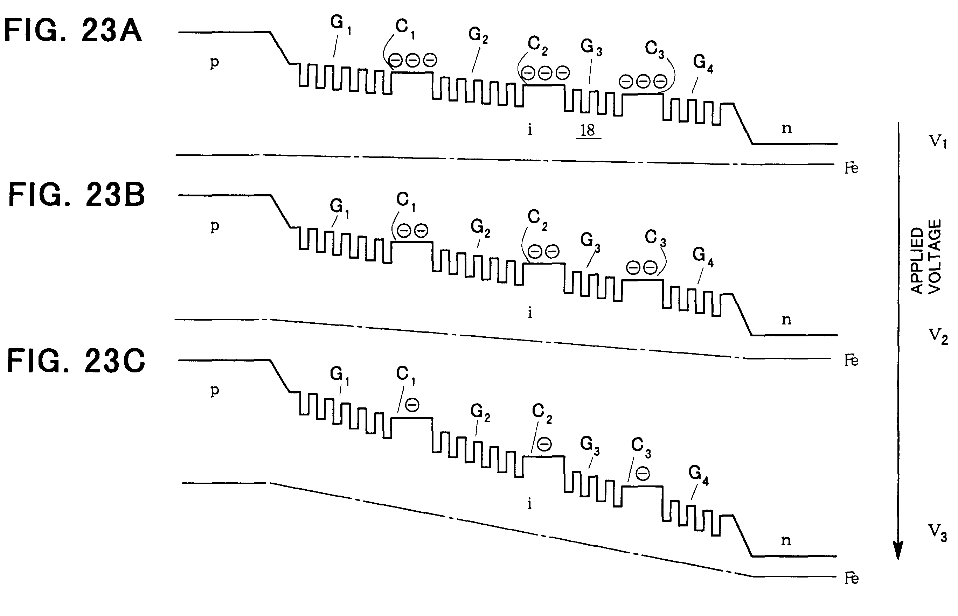

FIGS. 23A-23C are explanatory views showing the energy diagrams of the i-layer of a diode having a pin structure according to the present invention.

## DETAILED DESCRIPTION OF THE PREFERRED EMBODIMENTS

The invention will be more fully understood by reference to the following examples.

## Example 1

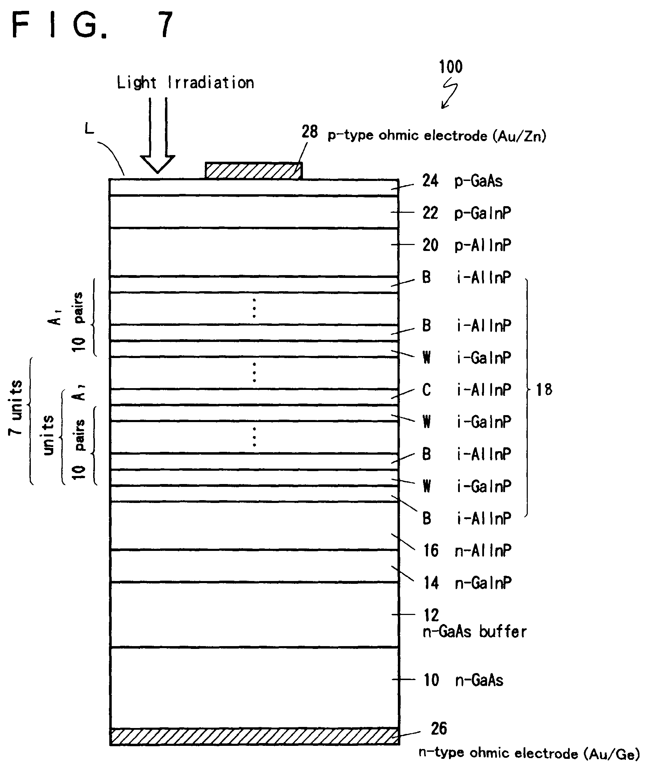

FIG. 7 is a sectional view of a pin diode 100 in which a multi-period layer is formed in an i-layer. The pin diode 100 has a substrate 10 made of gallium arsenide (GaAs). A GaAs buffer layer 12 of n-type conduction, having a thickness generally of 0.3 $\mu$m and an electron concentration of $2 \times 10^{18}/cm^3$, is formed on the substrate 10. An n-$Ga_{0.51}In_{0.49}P$ contact layer 14 of n-type conduction, having a thickness generally of 0.13 $\mu$m and electron concentration of $2 \times 10^{18}/cm^3$, is formed on the buffer layer 12. An n-$Al_{0.51}In_{0.49}P$ n-layer 16, having a thickness generally of 0.2 $\mu$m and an electron concentration of $1 \times 10^{18}/cm^3$, is formed on the contact layer 14. A non-doped i-layer 18 is formed on the n-layer 16. An $Al_{0.51}In_{0.49}P$ p-layer 20, having a thickness generally of 0.2 $\mu$m and a hole concentration of $1 \times 10^{18}/cm^3$, is formed on the i-layer 18. A p-$Ga_{0.51}In_{0.49}P$ contact layer 22 of p-type conduction, having a thickness generally of 0.13 $\mu$m and a hole concentration of $2 \times 10^{18}/cm^3$, is formed on the p-layer 20. A p-GaAs first contact layer 24 of p-type conduction, having a thickness generally of 0.06 $\mu$m and a hole concentration of $2 \times 10^{18}/cm^3$, is formed on the contact layer 22. An electrode layer 26 made of gold and germanium (Au/Ge), having a thickness generally of 0.2 $\mu$m, is formed so as to cover the entire back of the substrate 10. Another electrode layer 28 made of gold and zinc (Au/Zn), having a thickness generally of 0.2 $\mu$m, is formed on some portion of the first p-type contact layer 24.

A multi-period layer unit $A_1$ having a multi-quantum layer structure with 10 pairs of a non-doped $Ga_{0.51}In_{0.49}P$ first layer W and a non-doped $Al_{0.51}In_{0.49}P$ second layer B is formed in the i-layer 18. $A_2$, ..., $A_7$ are formed like $A_1$, and 7 multi-period layer units in total are formed in the i-layer 18.

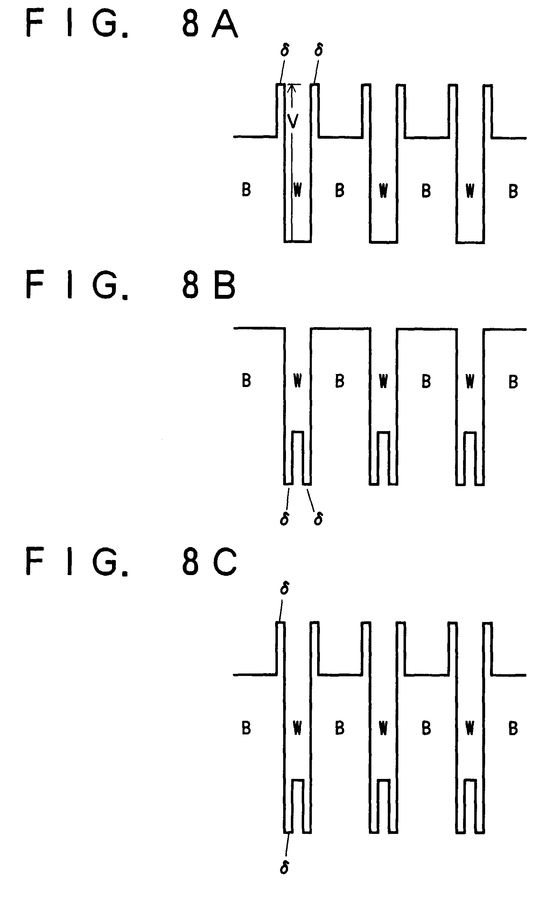

FIGS. 8A to 8C show a structure of the multi-period layer unit $A_1$ in detail. The first layer W has a thickness of 5 nm, and the second layer B has a thickness of 7nm. A non-doped $\delta$ layer made of $Al_{0.33}Ga_{0.33}In_{0.33}P$ is formed at each interface between the first layer W and the second layer B.

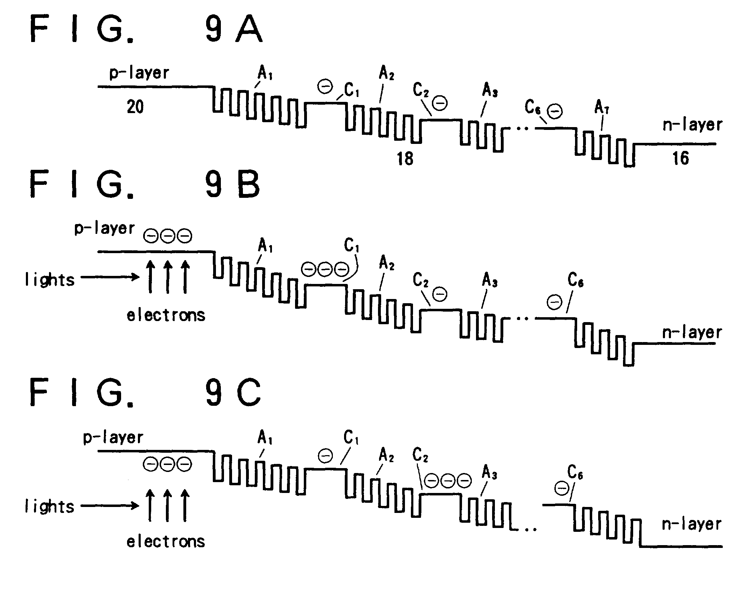

A non-doped $Al_{0.51}In_{0.49}P$ carrier confinement layer C, having a thickness of 14 nm, is formed between any multi-period layer units $A_1$ and $A_{i+1}$, respectively, as shown in FIG. 9.

The second layer B which contact to the p-layer 20 and the n-layer 16 have a thickness of 0.05 $\mu$m. The first second layer B was formed thicker than other second layers B in order to prevent conduction by tunneling effects from the n-layer 16 or the p-layer 20 into the first layer W. The substrate 10 has a diameter of 2.0 inches and the normal direction of its main surface is offset toward the [011] axis by 15 degree from the (100) plane.

The pin diode 100 was manufactured by gas source molecular beam epitaxial deposition (GS-MBE), which is an epitaxial growth method performed under extremely a high vacuum condition. GS-MBE is different from a conventional MBE, which supplies group III and V elements both from the solid sources. In GS-MBE, group III elements such as indium (In), gallium (Ga), and aluminum (Al) are supplied from a solid source and group V elements such as arsenic (As) and phosphorus (P) are supplied by heat decomposition of gas material such as $AsH_3$ and $PH_3$. Alternatively, the pin diode 100 can be manufactured by metal organic chemical vapor deposition (MOCVD).

Each multi-period layer units $A_1$ to $A_7$ reflects electrons, which are generated in the p-layer 20 as minority carriers, and electrons are not conducted in the i-layer 18. Although the $\delta$ layer is not shown in FIGS. 9A and 9B, it is present at each interface between the first layer W and the second layer B, as shown in FIGS. 8A to 8C. FIG. 9A shows an electric potential gradient occurring in the i-layer 18 as an insulation layer on the condition that a backward voltage is applied to the interface between the p-layer 20 and the n-layer 16 of the diode 100. Because of the backward voltage applied to the multi-period layer unit $A_1$, its reflectivity of electrons is lowered and minority carriers generated in the p-layer 20 start to flow as a small quantity of leakage current. The minority carriers are conducted in the first multi-period layer unit $A_1$, and flows into the first carrier confinement layer $C_1$. This accumulation of electrons in the confinement layer $C_1$ makes an electric potential gradient of the multi-period layer unit $A_1$ steeper and the multi-period layer unit $A_2$ adjacent to $A_1$ gentler. Consequently, the kinetic energy of electrons injected into the multi-period layer unit $A_1$ becomes larger than that used to design each thicknesses of the respective layers of the multi-period layer unit $A_1$. Consequently the reflectivity of the multi-period layer unit $A_1$ becomes smaller, and more electrons pass through the multi-period layer unit $A_1$ and are accumulated in the carrier confinement layer $C_1$. Then, the electric potential gradient of the second multi-period layer unit $A_2$ becomes gentler, and its reflectivity improves. Electrons are thus accumulated in the carrier confinement layer $C_1$ effectively.

Then, the same process occurs between the second and the third multi-period layer units $A_2$ and $A_3$, and electrons in the carrier confinement layer $C_1$ leak into an electron confinement layer $C_2$ by a small quantity. The electric potential gradient of the second multi-period layer unit $A_2$ becomes steeper, but, the electric potential gradients of the first and the third multi-period layer units $A_1$ and $A_3$ become gentler. Thus, the reflectivities of the first and the third multi-period layer unit improve.

Through the above process, electrons accumulated in the first carrier confinement layer $C_1$ are propagated to the second carrier confinement layer $C_2$, then to the other respective carrier confinement layers in the i-layer 18. Thus accumulated electrons are propagated from the p-layer 20 to the n-layer 16.

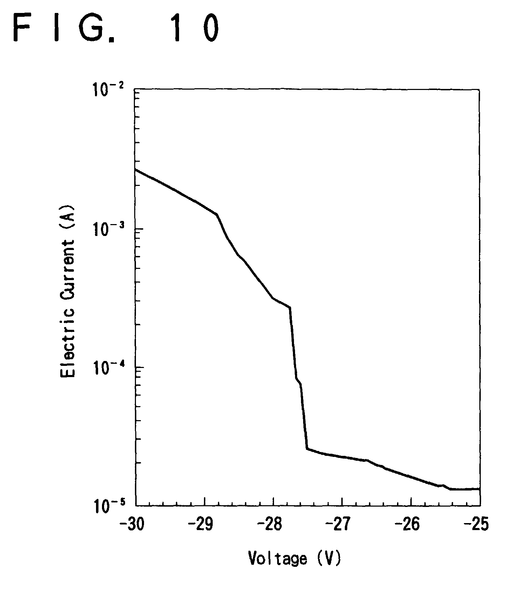

I-V characteristic was measured when the backward voltage is applied to the pin diode 100. As shown in FIG. 10, until a backward voltage is 27.6 V, the electric current is substantially small, about $10^{-5}$ A. when the backward voltage is above 27.6 V, the electric current increases sharply, at certain plural voltage values.

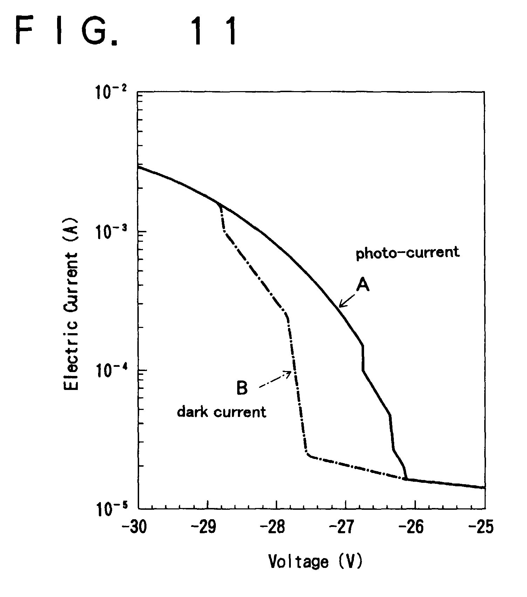

As shown in FIG. 7, a window L is formed on the surface of the p-layer 24. The p-layers 20-24 corresponding the window L function as a light receiver which receives lights and generates electrons. I-V characteristic was measured when the backward voltage is applied to the pin diode 100 and the result is shown in FIG. 11. Electrons, light-excited in the p-layer 20, are propagated through the i-layer 18 by a mechanism described above, as shown in FIG. 11, an electric current occurs for a small quantity of a backward voltage because of the electrons generated by light excitation. Also, the electric current increases step by step, at certain plural backward voltages.

As shown in FIG. 11, in the range between -26.2 V and -27.6 V, the electric current when the diode is irradiated by light, represented by A, is tenfold that of a dark current, represented by B. In this range, the electric current obtained when the diode is irradiated by light detector. Advantageously, the operating voltage of the diode is substantially lower compared to that of an avalanche photo diode in the prior art.

Example 2

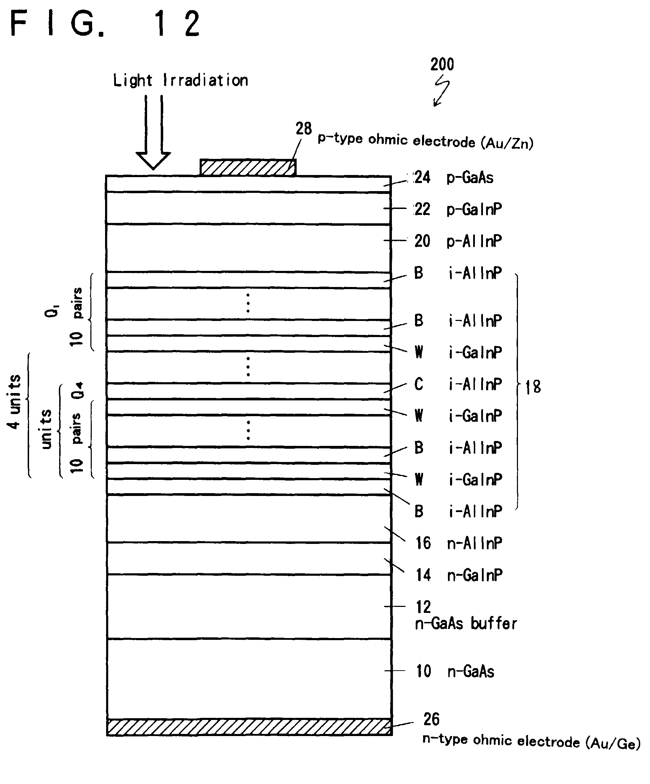

FIG. 12 shows a sectional view of a light-receiving device 200 having the same structure as that of the pin diode 100 in Example 1, except for that of the following.

A multi-period layer unit $Q_1$ having a multi-period layer structure with 10 pairs of a $Ga_{0.51}In_{0.49}P$ first layer W having a thickness of 5 nm, $Al_{0.51}In_{0.49}P$ second layer B having a thickness of 7 nm, and an non-doped $Al_{0.33}Ga_{0.33}In_{0.33}P$ $\delta$ layer having a thickness of 1.3 nm is formed in the i-layer 18. $Q_2$, ..., $Q_4$ are formed like $Q_1$, and 4 multi-period layer units in total are formed in the i-layer 18.

FIGS. 8A to 8C show a structure of the multi-period layer unit $Q_1$ in detail. Non-doped $Ga_{0.51}In_{0.49}P$ carrier confinement layers $C_1$ to $C_3$, each having a thickness of 20 nm, are formed between any multi-period layer units $Q_i$ and $Q_{i+1}$, respectively.

The second layers B which contact to the n-layer 16 and the p-layer 20 have a thickness of 0.05 $\mu$m, respectively. The substrate 10 has a diameter of 2.0 inches and the normal direction of its main surface is offset toward the [011] axis by 15 degree from the (100) plane, just as same as the substrate 10 of Example 1. The light-receiving device 200 was manufactured by gas source molecular beam epitaxial deposition (GS-MBE) as in Example 1. Alternatively, the light-receiving device 200 can be manufactured by metal organic chemical vapor deposition (MOCVD).

As shown in FIG. 2, as a forward voltage V applied to the interface between the p-layer 20 and the n-layer 16 of the light-receiving device 200 increases, an electric potential gradient occurring in the i-layer 18 becomes gentler until it becomes plane. In this condition, electrons do not flow because a reflection condition to electrons in multi-period layer units $Q_1$ to $Q_4$ is satisfied.

When light having an energy resonant to band width of carrier confinement layers $C_1$ to $C_3$ is incided, electrons are excited in the carrier confinement layers $C_1$ to $C_3$. An electron concentration in the carrier confinement layers $C_1$ to $C_3$ becomes larger, and many electrons become to exist at the levels higher than the bottom of a conduction band in the second layer B. The electrons in the n-layer 16 are conducted into the carrier confinement layers $C_1$ which is adjacent to the n-layer 16, and electrons in the carrier confinement layers $C_1$ are conducted into the carrier confinement layers $C_2$. Accordingly, electrons intervene each carrier confinement layers $C_1$ and are conducted to each carrier confinement layers at a high speed, by wave propagation of electrons as a wave. Thus electrons are conducted from the n-layer 16 to the p-layer 20 by a light-excitation at a high speed.

The light-receiving device 200 has a high opto-electric conversion effectivity because electrons, which are excited in the carrier confinement layers $C_1$ to $C_3$, function as a gate-controlled switch toward the conduction of electrons from the n-layer 16 to the p-layer 20. When electrons are not excited in the carrier confinement layers $C_1$ to $C_3$, a condition to reflect electrons is satisfied in the multi-period layer units $Q_1$ to $Q_4$. But when electrons are excited in the carrier confinement layers $C_1$ to $C_3$, the condition is not satisfied and electrons may be conducted in the multi-period layer units $Q_1$ to $Q_4$ as a wave. Accordingly, a switching velocity is considered to be larger.

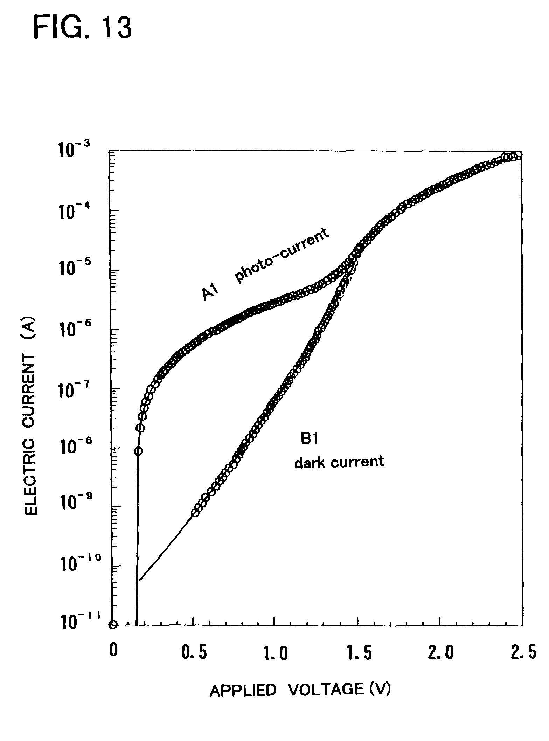

Measured I-V characteristic of the light-receiving device 200 is shown in FIG. 13. When light is incided, the photocurrent rises abruptly from $10^{-11}$ to $10^{-}$

7 A, or in the range of 4 orders, at the forward voltage of 0.2 V. But even if a forward voltage is applied to the device, a dark current is suppressed a lower value and degree of increasing is also suppressed. The phenomenon is occurred because the dark electrons reflected by the multi-period layer units and the dark current is kept comparatively lower. And the photocurrent when the device is incided by light, represented by A1, is about hundredfold that of a dark current, represented by B1. Additionally, the forward applied voltage at which an electric potential gradient in the i-layer 18 becomes plane is appeared to be 1 V. When an applied forward voltage is 1 V, the photocurrent is not less than $5 \times 10^{-6}$ A.

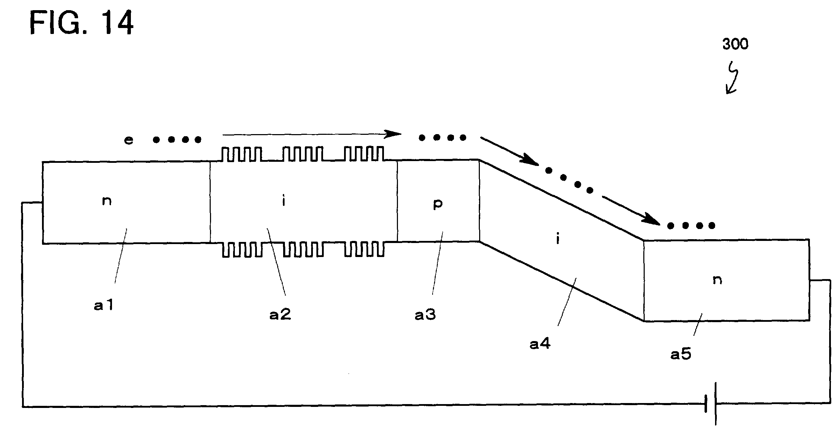

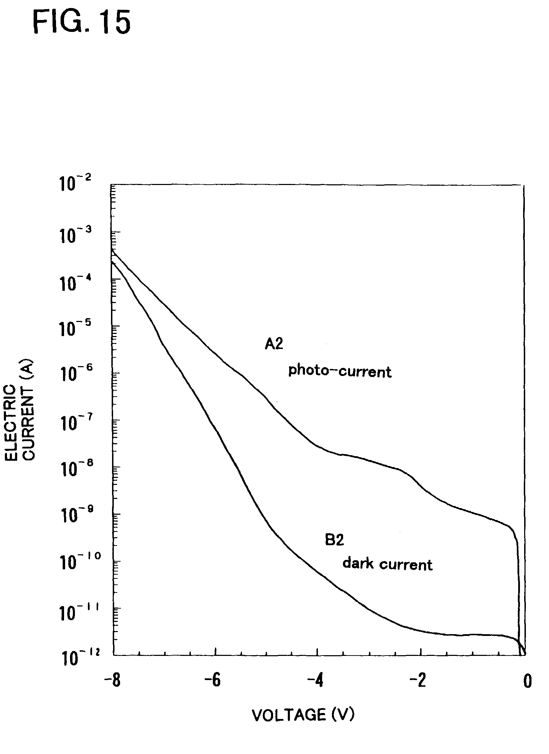

A light-receiving device 300 having an nipin structure shown in FIG. 14 is formed. the regions represented by a1, a2, a3 are the same regions as those in the light-receiving device 200 having an nip structure. A multi-period layer and a carrier confinement layer are formed in an i-layer a2. Regions a4 and a5 function to draw the photocurrent which flows into the p-type region a3 by a reverse external bias voltage. I-V characteristic was measured when the light-receiving device 300 is incided by light. As shown in FIG. 15, the photocurrent, represented by A2, is about thousandfold that of a dark current, represented by B2.

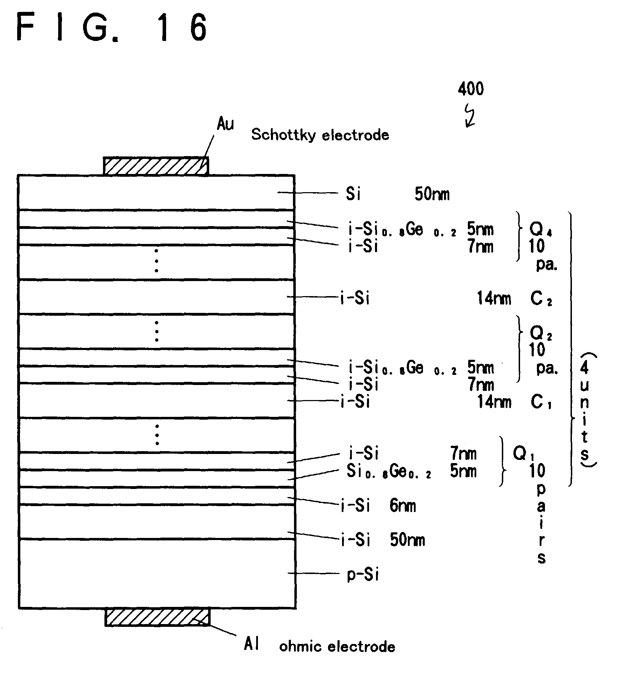

A light-receiving device 400 using Si/Ge compound semiconductor shown in FIG. 16 is formed. A first layer W made of $Si_{0.8}Ge_{0.2}$ and a second layer B made of Si are formed to have thicknesses of 5 nm and 7 nm, respectively. Carrier confinement layers $C_1$ to $C_3$ made of $Si_{0.8}Ge_{0.2}$ is formed to have a thickness of 20 nm. No $\delta$ layer is formed in the device 400.

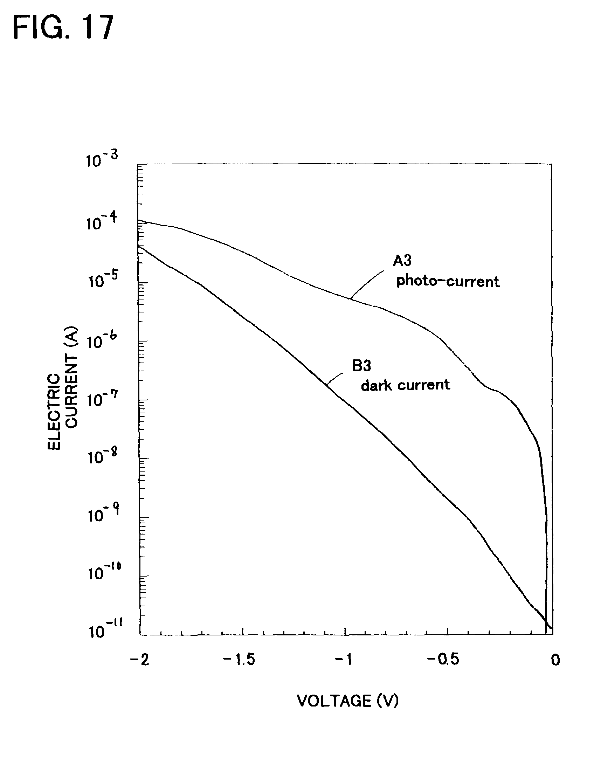

A characteristic of the device 400 was measured when the device is incided by light. As shown in FIG. 17, the photocurrent, represented by A3, is thousand fold that of a dark current, represented by B3. When the estimated forward voltage between n-layer a1 and p-layer a3 is about 0.9 V, the photocurrent rises abruptly. Further, by forming a $\delta$ layer, the characteristic of the light-receiving device 400 will be improved.

Accordingly, the light-receiving device of the present invention can obtain a larger S/N ratio compared with conventional devices.

Example 3

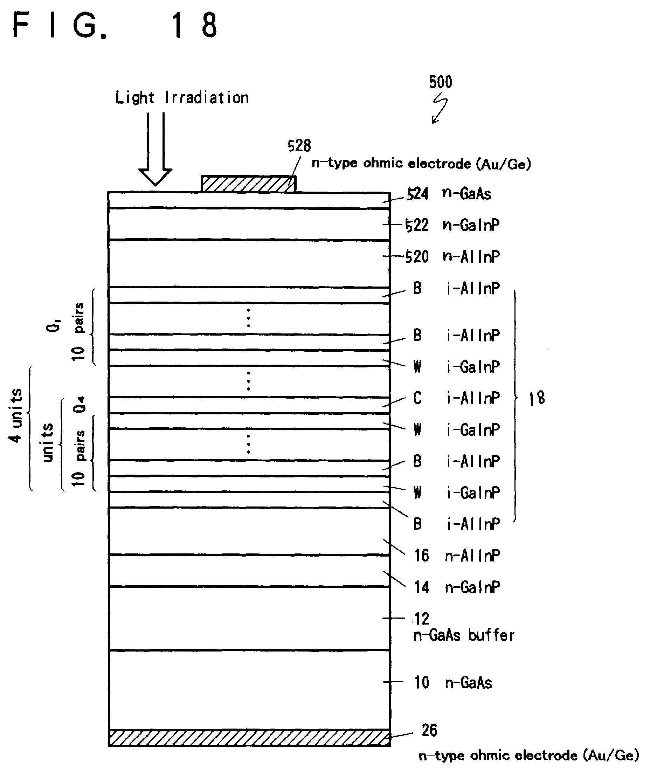

FIG. 18 is a sectional view of an nin variable capacity device 500 in which a multi-period layer is formed in an i-layer. The variable capacity device 500 has a substrate 10 made of gallium arsenide (GaAs). A GaAs buffer layer 12 of n-type conduction, having a thickness generally of 0.3 μm and an electron concentration of $2 \times 10^{18}/cm^3$, is formed on the substrate 10. An n-$Ga_{0.51}In_{0.49}P$ contact layer 14 of n-type conduction, having a thickness generally of 0.13 μm and electron concentration of $2 \times 10^{18}/cm^3$, is formed on the buffer layer 12. An n-$Al_{0.51}In_{0.49}P$ n-layer 16 of n-type conduction, having a thickness generally of 0.2 μm and an electron concentration of $1 \times 10^{18}/cm^3$, is formed on the contact layer 14. A non-doped i-layer 18 is formed on the n-layer 16. A $Al_{0.51}In_{0.49}P$ n-layer 520 of n-type conduction, having a thickness generally of 0.2 μm and an electron concentration of $1 \times 10^{18}/cm^3$, is formed on the i-layer 18. A $Ga_{0.51}In_{0.49}P$ second contact layer 522 of n-type conduction, having a thickness generally of 0.13 μm and an electron concentration of $2 \times 10^{18}/cm^3$, is formed on the n-layer 520. An n-GaAs first contact layer 524 of n-type conduction, having a thickness generally of 0.06 μm and an electron concentration of $2 \times 10^{18}/cm^3$, is formed on the second contact layer 522. An electrode layer 26 made of gold and germanium (Au/Ge), having a thickness generally of 0.2 μm, is formed so as to cover the entire back of the substrate 10. Another electrode layer 528 made of gold and germanium (Au/Ge), having a thickness generally of 0.2 μm, is formed on some portion of the first p-type contact layer 524.

A multi-period layer unit $A_1$ having a multi-quantum layer structure with 10 pairs of a non-doped $Ga_{0.51}In_{0.49}P$ first layer W and a non-doped $Al_{0.51}In_{0.49}P$ second layer B is formed in the i-layer 18. $A_2$, ..., $A_4$ are formed like $A_1$, and 4 multi-period layer units in total are formed in the i-layer 18.

FIGS. 8A to 8C show a structure of the multi-period layer unit $A_1$ in detail. The first layer W has a thickness of 5 nm, and the second layer B has a thickness of 7 nm. A non-doped $\delta$ layer made of $Al_{0.33}Ga_{0.33}In_{0.33}P$ is formed at each interface between the first layer W and the second layer B.

Non-doped $Al_{0.51}In_{0.49}P$ carrier confinement layers $C_1$ to $C_3$, having a thickness of 177 nm, is formed between any multi-period layer units $A_i$ and $A_{i+1}$, respectively.

The second layers B which contact to the n-layer 16 and the p-layer 520 have a thickness of 0.05 μm, respectively. The substrate 10 has a diameter of 2.0 inches and the normal direction of its main surface is offset toward the [011] axis by 15 degree from the (100) plane, just as same as the substrate 10 of Example 1. The variable capacity device 500 was manufactured by gas source molecular beam epitaxial deposition (GS-MBE) as in Example 1. Alternatively, the variable capacity device 500 can be manufactured by metal organic chemical vapor deposition (MOCVD).

FIG. 4A shows an electric potential gradient occurring in the i-layer 18 as an insulation layer on the condition that an external voltage is applied to the interface between the n-layer 520 and the n-layer 16 of the variable capacity device 500. Although the $\delta$ layer is not shown in FIGS. 4A to 4C, it is present at each interface between the first layer W and the second layer B, *as shown in FIGS. 8A to 8C.* Each multi-period layer units $A_1$ to $A_4$ reflects electrons when the external voltage is in the range of 0 to $V_1$ as shown in FIG. 4A. At this stage, electrons which exist in the i-layer 18 are not conducted in the i-layer and are confined in each carrier confinement layers $C_1$ to $C_3$, respectively. As a result, an effective thickness of a depletion layer becomes smaller, and an electrostatic capacity between the electrodes 26 and 528 becomes larger.

When the applied voltage V between the electrodes 26 and 528 become larger, a kinetic energy of electrons becomes larger and quantum-wavelength becomes smaller. As a result, the condition that each multi-period layer units $A_1$ to $A_4$ reflects electrons is not satisfied. Accordingly, electrons are conducted and a electron concentration of each carrier confinement layers $C_1$ to $C_3$ is decreased. Because each carrier confinement layers $C_1$ to $C_3$ becomes a depletion layer, which means that equivalently the thickness of the depletion layer in the i-layer 18 becomes larger, the capacity of the variable capacity device 500 decreases. Thus by applying a larger applied voltage V, the capacity can be decreased.

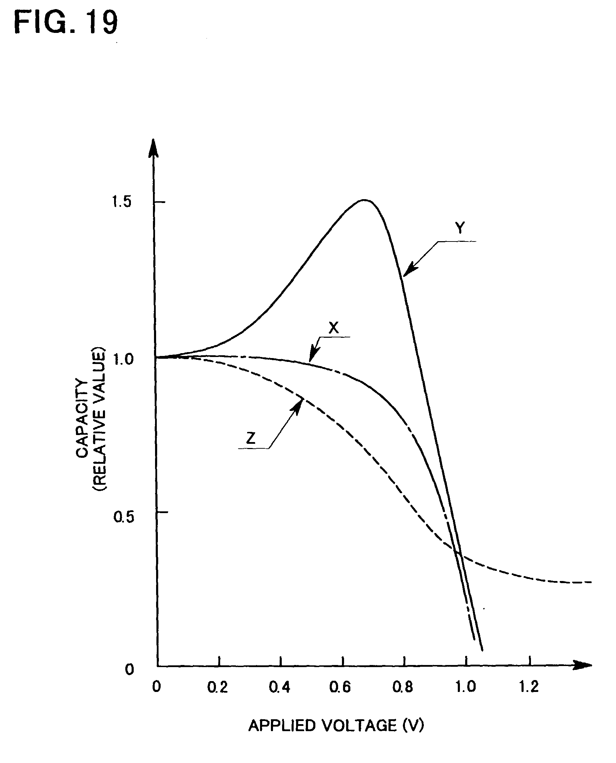

Capacity value with respect to an alternating current when a voltage V was applied as a bias voltage was measured by varying the respective value of the applied voltage V. FIG. 19 shows a result when the alternating currents are fixed at 100 kHz and 1 MHz, respectively. A characteristics X shows a curve when the alternating current is 1 MHz. When the applied voltage V is over 0.6 V, the capacity value of X suddenly drops. A characteristics Y shows a curve when the alternating current is 100 kHz. A peak of capacity value of Y is obtained when the applied voltage V is 0.7 V. And a characteristics Z shows a curve of a voltage-variable capacity device in the prior art. As shown in FIG. 19, it is obvious from the characteristics X and Y that a voltage-variation rate of capacity in the region over 0.8 V is improved compared with that of the prior art. And it is understood that a dynamic range of variable capacity is wider than that of the prior art.

Example 4

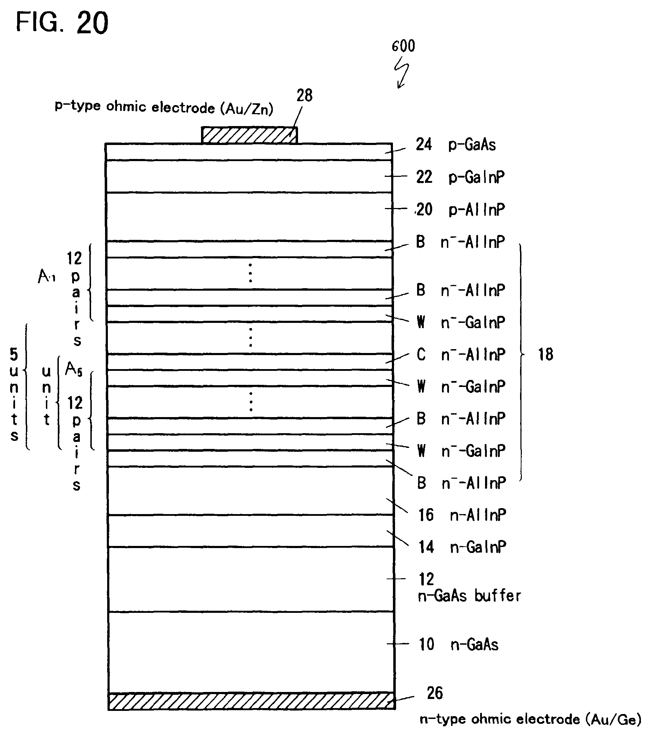

FIG. 20 is a sectional view of a pn$^-$n variable capacity device 600 in which a multi-period layer is formed in an n$^-$-type layer. The variable capacity device 600 has a GaAs substrate 10, an n-GaAs buffer layer 12, an n-$Ga_{0.51}In_{0.49}P$ contact layer 14 of n-type conduction, and an n-$Al_{0.51}In_{0.49}P$ n-layer 16, that are the same layers as those in the variable capacity device 500 in Example 3. An n$^-$-layer 18, having an electron concentration which becomes smaller in accordance with approaching to a p-layer 20, is formed on the n-layer 16. The p-$Al_{0.51}In_{0.49}P$ p-layer 20 of p-type conduction, having a thickness generally of 0.2 µm and a hole concentration of $1 \times 10^{18}/cm^3$, is formed on the n$^-$-layer 18. A p-$Ga_{0.51}In_{0.49}P$ second contact layer 22 of p-type conduction, having a thickness generally of 0.13 µm and a hole concentration of $2 \times 10^{18}/cm^3$, is formed on the p-layer 20. A p-GaAs first contact layer 24 of p-type conduction, having a thickness generally of 0.06 µm and a hole concentration of $2 \times 10^{18}/cm^3$, is formed on the second contact layer 22. An electrode layer 26 made of gold and germanium (Au/Ge), having a thickness generally of 0.2 µm, is formed so as to cover the entire back of the substrate 10. Another electrode layer 28 made of gold and zinc (Au/Zn), having a thickness generally of 0.2 µm, is formed on some portion of the first p-type contact layer 24.

The n$^-$-layer 18 has an electron concentration of $3 \times 10^{16}/cm^3$. A multi-period layer $A_1$ having a multi-quantum layer structure with 12 pairs of a $Ga_{0.51}In_{0.49}P$ first layer W and an $Al_{0.51}In_{0.49}P$ second layer B is formed in the n$^-$-layer 18. $A_2$, ..., $A_5$ are formed like $A_1$, and 5 multi-period layer units in total are formed in the n$^-$-layer 18.

FIG. 8A shows a structure of the multi-period layer unit $A_1$ in detail. The first layer W has a thickness of 5 nm, and the second layer B has a thickness of 7 nm. A non-doped δ layer made of $Al_{0.33}Ga_{0.33}In_{0.33}P$, having a thickness of 1.3 nm, is formed at each interface between the first layer W and the second layer B.

A non-doped $Al_{0.51}In_{0.49}P$ carrier confinement layers $C_1$ to $C_4$, each having a thickness of 14 nm, is formed between any multi-period layer units $A_i$ and $A_{i+1}$, respectively.

The second layers B which contact to the n-layer 16 and the p-layer 20 have a thickness of 0.05 µm, respectively. The substrate 10 has a diameter of 2.0 inches and the normal direction of its main surface is offset toward the [011] axis by 15 degree from the (100) plane, just as same as the substrate 110 of Example 1. The variable capacity device 600 was manufactured by gas source molecular beam epitaxial deposition (GS-MBE) as in Example 1. Alternatively, the variable capacity device 500 can be manufactured by metal organic chemical vapor deposition (MOCVD).

FIG. 6A shows an electric potential gradient occurring in the n$^-$-layer 18 because of a higher resistivity compared with the p-layer 20 or the n-layer 16 on the condition that a backward voltage is applied to the interface between the p-layer 20 and the n-layer 16 of the variable capacity device 600. Although the δ layer is not shown in FIGS. 6A to 6C, it is present at each interface between the first layer W and the second layer B, as shown in FIGS. 8A to 8C. Although only two carrier confinement layers $C_1$ and $C_2$ are shown in FIGS. 6A to 6C, four carrier confinement layers $C_1$ to $C_4$ exist as described above. Although only five pairs of layers in each of multi-period layer units are shown in FIGS. 6A to 6C, they exist in twelve pairs. Each multi-period layer units $A_1$ to $A_5$ reflects electrons when an external voltage is in the range of 0 to $V_1$ as shown in FIG. 6A. At this stage, electrons which exist in the n$^-$layer 18 are not conducted in the n$^-$-layer 18 and are confined in each carrier confinement layers $C_1$ to $C_4$, respectively. As a result, an effective thickness of a depletion layer becomes smaller, and an electrostatic capacity between the electrodes 26 and 28 becomes larger.

When the applied voltage V between the electrodes 26 and 28 becomes larger, a kinetic energy of electrons become larger and quantum-wavelength become smaller. As a result, the condition that each multi-period layer units $A_1$ to $A_5$ reflects electrons is not satisfied. Accordingly, electrons are conducted and an electron concentration of each carrier confinement layers $C_1$ to $C_4$ is decreased. Because each carrier confinement layers $C_1$ to $C_4$ becomes a depletion layer, which means that equivalently the thickness of the depletion layer in the $n^-$-layer 18 becomes larger, the capacity of the variable capacity device 600 decreases. Thus by applying a larger applied voltage V, the capacity can be decreased.

Example 5

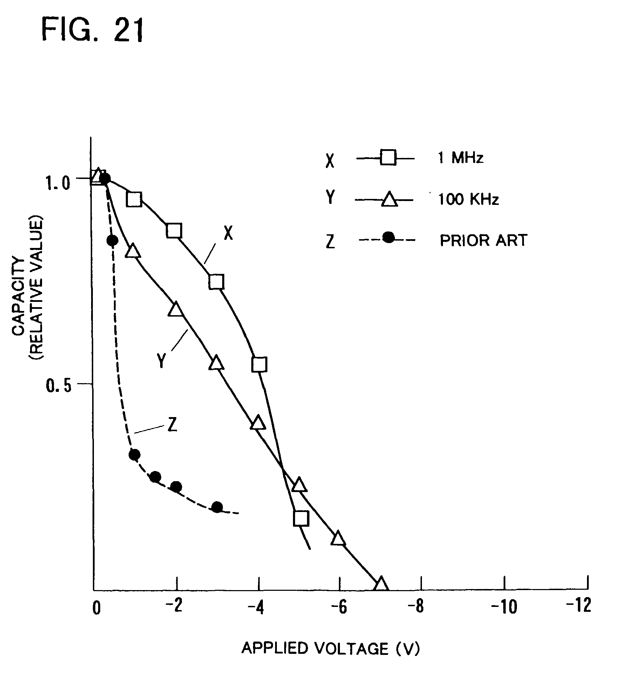

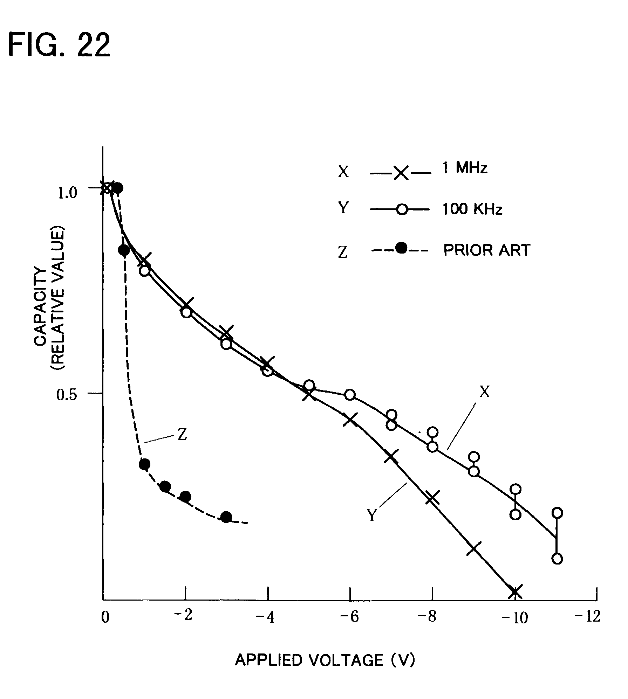

In this embodiment, a variable capacity device has the same structure as that of the variable capacity device 600 of FIG. 20. A thickness of each carrier confinement layers $C_1$ to $C_4$ is duplicated to 8 nm and a measured capacity is shown in FIG. 22. Comparing FIG. 22 with FIG. 21, a voltage-variation rate of capacity becomes smaller in accordance with a thickness of each carrier confinement layers $C_1$ to $C_4$ being larger. The dynamic range of capacity of both obtained devices are improved to be wider compared with that of the prior art.

As described above, with respect to a semiconductor device with a multi-period layer having plural periods of a pair of a first layer and a second layer, where the second layer has a wider band gap than the first layer, an interference effect of quantum-wave of carriers in the multi-period layer can be improved by forming a plural multi-period layers each having a carrier confinement layer, which has a wider band gap than the first layer, or by forming a plural multi-period layers each having a carrier confinement layer, which has a narrower band gap than the second layer. In the present invention, it is important to form a carrier confinement layer at an interface of multi-period layers adjacent to each other, when forming plural numbers of multi-period layers having a interference effect of quantum-wave of electrons. As a result, a multi-period layer in the present invention is not limited to a reflection of carriers.

In the embodiments, a $\delta$ layer is formed in the device. The $\delta$ layer improves the reflectivity of the device. Alternatively, because the reflectivity can be obtained by a multi-period layer, the $\delta$ layer is not necessarily needed.

In the embodiments, plural numbers of multi-period layers are connected in series, with a carrier confinement layer lying between each of the multi-period layers. Alternatively, an arbitrary pairs of a first layer and a second layer can be formed in the multi-period. Also alternatively, an arbitrary numbers of carrier confinement layers can be formed in an arbitrary numbers of multi-period layers.

Further, in Examples 1-5, the multi-period layer was made of ternary compounds including $Ga_{0.51}In_{0.49}P$ and $Al_{0.51}In_{0.49}P$. Alternatively, the multi-period layer can be made of quaternary compounds such as $Al_xGa_yIn_{1-x-y}P$ or $Al_xGa_yIn_{1-x-y}As$, selecting arbitrary composition ratio within the range of $0 \leqq x \leqq 1$, $0 \leqq y \leqq 1$, and $0 \leqq x+y \leqq 1$.

As another alternative, the multi-period layer can be made of group III-V compound semiconductor, group II-VI compound semiconductors, Si and Ge, and semiconductors of other hetero-material. The desirable compositions are as follows. Each combinations is represented by a composition of a layer having a wide band width / a layer having a narrow band width // a substrate. And x and y are arbitrary values wherein $0 \leqq x \leqq 1$ and $0 \leqq y \leqq 1$, as long as they are not specified.

   〈1〉 $Al_xIn_{1-x}P / Ga_yIn_{1-y}P$ // GaAs
   〈2〉 $Al_xGa_{1-x}As$ / GaAs // GaAs
   〈3〉 $Ga_xIn_{1-x}P$ / InP // InP
   〈4〉 $Ga_xIn_{1-x}P / Ga_xIn_{1-x}As$ // GaAs
   〈5〉 AlAs / $Al_xGa_{1-x}As$ // GaAs ($0.8 \leqq x \leqq 0.9$)
   〈6〉 InP / $Ga_xIn_{1-x}As_yP_{1-y}$ // GaAs
   〈7〉 Si / $SiGe_x$ // arbitrary material ($0.1 \leqq x \leqq 0.3$)
   〈8〉 Si / $SiGe_xC_y$ // arbitrary material ($0.1 \leqq x \leqq 0.3$, $0 < y \leqq 0.1$)
   〈9〉 $Al_{x1}Ga_{y1}In_{1-x1-y1}N$ / $Al_{x2}Ga_{y2}In_{1-x2-y2}N$ // Si, SiC, GaN, or sapphire ($0 \leqq x_1, x_2, y_1, y_2, x_1+y_1, x_2+y_2 \leqq 1$)

While the invention has been described in connection with what are presently considered to be the most practical and preferred embodiments, it is to be understood that the invention is not to be limited to the disclosed embodiments, but on the contrary, the description is intended to cover various modifications and equivalent arrangements included within the spirit and scope of the appended claims. The present document claims the benefit of Japanese priority document, filed in Japan on October 21, 1998, the entire contents of which is incorporated herein by reference.

Obviously, numerous modifications and variations of the present invention are possible in light of the above teachings. It is therefore to be understood that within the scope of the appended claims, the invention may be practiced otherwise than as specifically described herein.

Plurality of multi-period layer units with a plural-layer structure, having plural periods of a pair of a first layer W and a second layer B are formed in a semiconductor device. The second layer B has wider band gap than the first layer W. A carrier confinement layer having a wider band width than the first layer W is formed at each interface of the multi-period layer units, and plurality of multi-period layer units are connected in series. Accordingly, a semiconductor device with a first structure is formed. Plurality of multi-period layer units with a plural-layer structure, having plural periods of a pair of a first layer W and a second layer B are formed in a semiconductor device. The second layer B has wider band gap than the first layer W. A carrier confinement layer having a narrower band width than the second layer B is formed at each interface of the multi-period layer units, and plurality of multi-period layer units are connected in series. Accordingly, a semiconductor device with a second structure is formed. The semiconductor device having the first structure can be effectively applied to a pin-type photodiode and a voltage-variable capacity, and the semiconductor device having the second structure can be effectively applied to a light-receiving device.

## Claims

1. A semiconductor device comprising:

    a multi-period layer unit having a plural layer structure, plural periods of a pair of a first layer and a second layer as a unit being formed in said multi-period layer unit, said second layer having a wider band gap than said first layer; and
    a carrier confinement layer having a wider band gap than said first layer, which is formed between the adjacent two of said multi-period layer units,
    wherein plurality of said multi-period layer units and said carrier confinement layer therebetween are formed in series.

2. A semiconductor device according to claim 1, further comprising:

    a p-layer, an n-layer and an i-layer which is formed between said p-layer and said n-layer; wherein said carrier confinement layer and said multi-period layer are formed in said i-layer.

3. A semiconductor device according to claim 2, wherein a light receiver is formed in said p-layer or said n-layer and said light receiver generates carriers to inject into said i-layer.

4. A semiconductor device comprising:

    a multi-period layer unit having a plural layer structure, plural periods of a pair of a first layer and a second layer as a unit being formed in said multi-period layer unit, said second layer having a wider band gap than said first layer; and
    a carrier confinement layer having a narrower band gap than said second layer, which is formed between adjacent two of said multi-period layer units,
    wherein plurality of said multi-period layer units and said carrier confinement layer therebetween are formed in series.

5. A semiconductor device according to claim 4, wherein said semiconductor device is a light-receiving device having a pin junction structure, and said carrier confinement layer and said multi-period layer are formed in said i-layer.

6. A semiconductor device according to claim 4, wherein said semiconductor device is a light-receiving device, and said carrier confinement layer and said multi-period layer are formed in an n-layer or a p-layer.

7. A semiconductor device according to claim 6, further comprising a pn junction structure.

8. A semiconductor device according to claim 4, wherein said carrier confinement layer has the same band width as that of said first layer.

9. A semiconductor device according to claim 1, wherein said semiconductor device is a variable capacity device having an nin or pip junction structure, and said carrier confinement layer and said multi-period layer are formed in said i-layer.

10. A semiconductor device according to claim 1, wherein said semiconductor device is a variable capacity device having a $pn^-n$, $pp^-n$ or pin junction structure, and said carrier confinement layer and said multi-period layer are toned in an $n^-$-layer, a $p^-$ layer or an i-layer.

11. A semiconductor device according to claim 1, wherein said carrier confinement layer has the same band width as that of said second layer.

12. A semiconductor device according to claim 3, wherein said carrier confinement layer has the same band width as that of said second layer.

13. A semiconductor device according to claim 9, wherein said carrier confinement layer has the same band width as that of said second layer.

14. A semiconductor device according to claim 10, wherein said carrier confinement layer has the same band width as that of said second layer.

# F I G. 1 A

# F I G. 1 B

FIG. 2

EP 0 996 169 A2

## FIG. 3A

n                    i                    n

## FIG. 3B

n

i

n

n

FIG. 4A

FIG. 4B

FIG. 4C

EP 0 996 169 A2

APPLIED VOLTAGE

$V_1$

$V_2$

$V_3$

16

# FIG. 5A

p

Fe

# FIG. 5B

n⁻

n

p

# FIG. 5C

Fe

n⁻

p

n

i

Fe

n

# F I G. 7

F I G. 8 A

F I G. 8 B

F I G. 8 C

EP 0 996 169 A2

# FIG. 9A

# FIG. 9B

# FIG. 9C

# F I G. 1 0

# F I G. 1 1

# F I G. 1 2

Light Irradiation

200

28 p-type ohmic electrode (Au/Zn)

24 p-GaAs
22 p-GaInP
20 p-AlInP
B i-AlInP
B i-AlInP
W i-GaInP
C i-AlInP
W i-GaInP
B i-AlInP
W i-GaInP
B i-AlInP

18

$Q_1$ 10 pairs

4 units

units

$Q_4$ 10 pairs

16 n-AlInP
14 n-GaInP
12 n-GaAs buffer
10 n-GaAs
26 n-type ohmic electrode (Au/Ge)

24

# FIG. 13

FIG. 14

300

n a1  i a2  p a3  i a4  n a5

EP 0 996 169 A2

# FIG. 15

# F I G. 1 6

# FIG. 17

# F I G. 1 8

Light Irradiation

500

528
n-type ohmic electrode (Au/Ge)

524 n-GaAs

522 n-GaInP

520 n-AlInP

B i-AlInP

B i-AlInP

W i-GaInP

C i-AlInP

W i-GaInP

B i-AlInP

W i-GaInP

B i-AlInP

16 n-AlInP

14 n-GaInP

12
n-GaAs buffer

10 n-GaAs

26

n-type ohmic electrode (Au/Ge)

Q₁ 10 pairs

4 units

Q₄ 10 pairs units

18

# FIG. 19

# FIG. 20

600

p-type ohmic electrode (Au/Zn)   28

| | |
|---|---|
| | 24   p-GaAs |
| | 22   p-GaInP |
| | 20   p-AlInP |
| | B   n⁻-AlInP |

B   n⁻-AlInP

12 pairs  A₁

B   n⁻-AlInP
W   n⁻-GaInP
C   n⁻-AlInP     18
W   n⁻-GaInP

5 units   unit  A₅  12 pairs

B   n⁻-AlInP
W   n⁻-GaInP
B   n⁻-AlInP

16   n-AlInP
14   n-GaInP
12   n-GaAs buffer
10   n-GaAs
26

n-type ohmic electrode (Au/Ge)

# FIG. 21

# FIG. 22

APPLIED VOLTAGE (V)

FIG. 23A

FIG. 23B

FIG. 23C

EP 0 996 169 A2